Europäisches Patentamt

(19) European Patent Office

Office européen des brevets

(11) Publication number: **0 076 562**
**B1**

(12) **EUROPEAN PATENT SPECIFICATION**

(45) Date of publication of patent specification: **22.07.87**

(21) Application number: **82303953.2**

(22) Date of filing: **27.07.82**

(51) Int. Cl.⁴: **C 08 J 7/18,** B 29 C 71/04,
C 23 C 14/00, C 04 B 41/00 //
H01J37/32

(54) **Substrate with chemically modified surface and method of manufacture thereof.**

(30) Priority: **07.10.81 US 309525**

(43) Date of publication of application:
**13.04.83 Bulletin 83/15**

(45) Publication of the grant of the patent:
**22.07.87 Bulletin 87/30**

(84) Designated Contracting States:
**BE DE FR GB IT LU NL SE**

(56) References cited:
**EP-A-0 055 326**
**DE-A-3 144 016**
**FR-A-2 402 301**

**J.R. HOLLAHAN et al.: "Techniques and
applications of plasma chemistry", 1974, Wiley
Interscience, New York, USA**

**The file contains technical information
submitted after the application was filed and
not included in this specification**

(73) Proprietor: **Becton, Dickinson and Company
Mack Centre Drive P.O. Box 2224
Paramus New Jersey 07652-1149 (US)**

(72) Inventor: **Dunn, Terry S.
1300 Canterbury Road
Raleigh North Carolina (US)**
Inventor: **Montgomery, David B.
801 Brookgreen Dr.
Cary North Carolina (US)**
Inventor: **Williams, Joel L.
1306 Walnut Street
Cary North Carolina (US)**

(74) Representative: **Ruffles, Graham Keith et al
MARKS & CLERK 57-60 Lincoln's Inn Fields
London WC2A 3LS (GB)**

Courier Press, Leamington Spa, England.

## Description

The present invention relates generally to substrates with chemically modified surfaces. More particularly, the invention relates to the modification of the surfaces of organic and inorganic substrates by subjecting the surface of the substrate to selected species of a plasma of a vaporized material.

The use of a plasma to modify the surface of various substrates is well known. Plasmas are defined as highly reactive and energetic mixtures of ions, electrons and photons with properties distinct from ordinary gases. Four types of man-made plasmas are available; these are thermal plasmas, discharge plasmas, beam plasmas and hybrid plasmas, such as corona and ozonizer-type discharges. Electrical discharge plasmas are usually generated by use of either DC sources or AC sources of a frequency through the microwave range at power levels from about 1.0 W to about 10 kW.

Among the applications for which such man-made plasmas have been used or proposed are the modification of the surfaces of inorganic and organic substrates. Such modification is generally effected by forming a plasma of inorganic or organic gaseous species and contacting the substrate with the full spectrum of active species from the plasma that is formed. It is known that the full spectrum of active species available in the plasma are operable to modify the surface of a substrate, such as by the formation of a polymeric coating thereon or by the grafting of a variety of chemical species to the substrate surface. For example, the applications of plasma-solid reactions to polymers are surveyed at pages 116 to 122 of "Techniques and Applications of Plasma Chemistry", 1974, Wiley Interscience, New York, USA. Specific applications which are mentioned include packaging, electronics, construction, and clothing industries.

Quite often, the material from which the plasma is formed is selected with respect to the substrate with which it will or can interact and the modification of the surface which results by contacting the substrate with the plasma is not a modification which is desired or which produces a desired result. For example, air or oxygen plasmas have been used to modify the surface of polymeric materials, such as polyethylene, for the purpose of increasing their adhesive or printing property but the modified surfaces are not useful for other purposes, such as tissue culture growth.

The present invention provides a process for the modification of organic and inorganic. substrates, including polymeric materials and metals, regardless of thickness, and which is independent of substrate composition, so as to provide specific chemical functional groups on the surface of the substrate. Such process is suitable for any application requiring specific surface chemistry, such as tissue culture products and protein-antibody binding or coupling to surfaces for purposes such as immunoassay.

Thus, in accordance with the present invention, there are provided processes for irreversibly modifying the surfaces of organic and inorganic substrates. More particularly, in accordance with the present invention, the surfaces of organic and inorganic substrates are irreversibly modified by grafting specific chemical functional species onto the surface of the substrate by contacting such surfaces with selected components of a plasma of a vaporized material. The plasma used is a low energy or cold plasma, such as an electrical glow discharge or corona discharge plasma. The surfaces which are modified in accordance with this invention have specific chemical functional groups grafted onto the surface of the substrate and provide suitable surface chemistry for applications such as tissue culture products and protein-antibody binding or coupling.

In a first embodiment of the present invention there is provided a process for modifying the surface of organic materials, specifically organic polymeric materials comprising

Providing an organic substrate within a reaction zone.

Introducing a vaporized material into the reaction zone. The material is one which is suitable for providing a plasma such as under electrical discharge conditions. Suitable materials include, but are not limited to oxygen, nitrogen, halogen, sulfur and compounds thereof.

Subjecting the material in the reaction zone to an ionizing process. A plasma is formed which includes neutral material, positive ions of the material, negative ions of the material, electrons and photons.

Preventing at least one of the components of the plasma from contacting the surface of the organic substrate in the reaction zone. Contacting the surface of the substrate with the remainder of the components of the plasma in the reaction zone, and

Forming specific functional groups of the material on the surface of the organic substrate.

The present invention is based on the discovery that exclusion of various reactive species of a plasma from contact with a substrate in the presence of the plasma can be employed to provide specific chemical functional groups on the surface of the substrate. The exclusion of plasma species from contact with a substrate is already known *per se* for the ion-milling of microelectronics components (see French Patent Specification 2 402 301).

The present invention will be more fully described with reference to the drawings, wherein:

Fig. 1 is a schematic diagram of apparatus which can be employed in the practice of the invention,

Fig. 2 is a perspective view of a sample holder used in the apparatus of Fig. 1.

Fig. 3 through Fig. 7 are x-ray photoelectron spectroscopy scans (ESCA) of various substrates, some of which have been treated in accordance with the present invention.

Fig. 8 is a plot illustrating differences in oxygen to carbon ratios which occur at various energy levels with different species of plasma.

Referring now to the figures, other features and advantages of the present invention will be described with reference to a particular material suitable for forming a plasma, i.e., oxygen. It should be understood, however, that the processes of the invention are equally suitable for use with other materials capable of forming a plasma, such as nitrogen, sulfur, ammonia, halogen, compounds thereof and mixtures thereof.

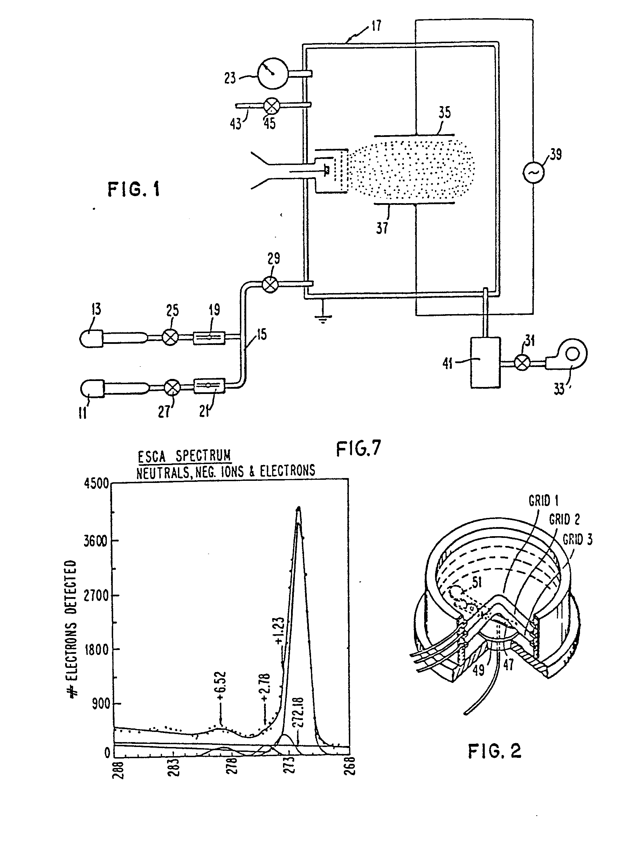

As shown in Fig. 1 there is provided a first gas reservoir 11, a second gas reservoir 13 with conduit means 15 to deliver either or both a first gas and a second gas to a vacuum chamber 17. Flow meters 19 and 21 are provided for measuring gas flow rate and a vacuum gauge 23 is provided to monitor the pressure within the vacuum chamber 17. Valves 25, 27 and 29 are provided to regulate the flow rate of the gas in the first gas reservoir 11, the second gas reservoir 13 and the gas entering the vacuum chamber 17. Prior to use, the vacuum chamber 17 is evacuated by opening valve 31 to vacuum pump 33. Suitable electrodes 35 and 37 are connected to a suitable voltage source 39. The reactor system also includes a trap 41, vent conduit 43 and its valve 45.

As best seen in Fig. 2, a substrate 47 to be treated in accordance with the invention is placed in a sample holder 51 and disposed within the vacuum chamber 17. The sample holder includes a grid assembly of three grids, designated grid 1, grid 2 and grid 3. A collector 49 which can be electrically biased is disposed on the other side of the sample from the grid system. The sample is held in place between grid 3 and the collector by means of a suitable holder 51.

In operation, any of the three grids or the collector can be biased with positive or negative charge to repel selective components of a plasma generated between the electrodes 35 and 37. The substrate in the sample holder is then subjected to reaction with those components of the plasma which are not repelled.

The present invention can be employed to alter the surfaces of solid polymeric materials, including natural and synthetic addition and condensation polymers. Such polymeric materials include polyolefins, such as polyethylene, polypropylene, polyisobutylene and ethylene-alpha-olefin copolymers, acrylic polymers and copolymers, such as polyacrylate, polymethylmethacrylate, polyethylacrylate; vinyl halide polymers and copolymers, such as polyvinyl chloride; polyvinyl ethers, such as polyvinyl methyl ether; polyvinylidene halides, such as polyvinylidene fluoride and polyvinylidene chloride; polyacrylonitrile, polyvinyl ketones; polyvinyl amides; polyvinyl aromatics, such as polystyrene, polyvinyl esters, such as polyvinyl acetate; copolymers of vinyl monomers with each other and olefins, such as ethylenemethyl methacrylate copolymers, acrylonitrile-styrene copolymers, ABS resins, and ethylene-vinyl acetate copolymers; natural and synthetic rubbers, including butadiene-styrene copolymers, polyisoprene, synthetic polyisoprene, polybutadiene, butadiene-acrylonitrile copolymers, polychloroprene rubbers, polyisobutylene rubber, ethylene-propylene rubber, ethylene-propylenediene rubbers, isobutylene-isoprene copolymers and polyurethane rubbers, polyamides, such as Nylon 66 and polycaprolactam; polyesters such as polyethylene terephthalate, alkyd resins; phenol-formaldehyde resins; urea-formaldehyde resins, melamine-formaldehyde resins; polycarbonates; polyoxymethylenes; polyimides; polyethers; epoxy resins, polyurethanes; wool; cotton; silk; rayon; rayon-triacetate; cellulose, cellulose acetate, cellulose butyrate; cellulose acetate-butyrate; cellophane; cellulose nitrate; cellulose propionate; cellulose ethers; and carboxymethyl cellulose.

Inorganic materials, the surfaces of which can be modified in accordance with the invention, include non-metals, such as graphite; metals, such as iron, aluminum, tin, copper and nickel; metal and other elemental oxides; such as magnesium oxide, silica, alumina and titania; minerals, such as clay, pyrite and asbestos; salts, such as sodium chloride and calcium carbonate; and such synthetic compositions as glass and refactories.

The substrates, whether organic or inorganic, can be any shape, such as continuous or particulate, porous or impervious, and large or small. The invention can be employed for altering the surfaces of crystals, powders, plates, strips, films, sheets, wire, fibers, fabrics, filaments, tubing, and cast, extruded or compressed articles, and the like.

In respect to oxygen, the plasma species formed when oxygen is caused to undergo electrical glow discharge conditions are set forth in Table 1 hereinbelow:

TABLE 1
Oxygen Plasma Species

| Species* | Atomic Oxygen | Molecular Oxygen |
|---|---|---|
| n (neutral) | $\cdot O \cdot$ | $^3O_2$ $(^3\Sigma_g)$, $^1O_2$ $(^1\Delta_g)$ |
| $n^+$ (positive) | $\cdot \dot{O} \cdot^+$, $\cdot \dot{O} \cdot^{+2}$ | $O_2 \cdot^+$, $O_2^{+2}$ |
| $n^-$ (negative) | $O \cdot^-$, $O^{-2}$ | $O_2 \cdot^-$, $O_2^{-2}$ |

* All species=n, $n^+$, $n^-$, $e^-$, hv

In the following examples, a substrate of a polystyrene strip is subjected to various components of an oxygen plasma. The substrate is then examined by x-ray photoelectron spectroscopy (ESCA) to determine

3

the nature of the chemical functional groups on the surface of the polystyrene substrate. In recent years, ESCA has evolved into a powerful tool available for the investigation of polymer surfaces to a depth of 10 nm (100 Å). ESCA is used to measure the binding energy shift and the results are tabulated by a plot which discloses the binding energy shift relative to particular functional groups. In Table 2 hereinbelow the binding energy shift range for various chemical functional groups introduced by an oxygen plasma is shown. The binding energy shift range figures set forth in Table 2 are established by reference to standard curves relating to ESCA technique. In particular, see C. Wagner, W. Riggs, L. Davis, J. Moulder, and G. Muilenberg. 1979. *Handbook of X-Ray Photoelectron Spectroscopy,* Perkin-Elmer Corporation, Physical Electronics Division, Minnesota; D. T. Clark and A. Dilks, *J. Polym. Sci. Polym. Chem. Ed.,* 17, 957 (1979) and D. T. Clark, B. J. Cromarty, and A. Dilks, *J. Polym. Sci. Polym. Chem. Ed.* 16, 3173 (1978) for much of the background data for the study of surface-oxidized hydrocarbon polymers by ESCA techniques.

TABLE 2
Binding Energy Shifts Associated with Various Chemical Species Introduced by Oxygen Plasma

| Binding Energy Shift Range (eV) | 1.2 — 1.3 | 1.4 — 1.6 | 1.7 — 1.9 | 2.0 — 2.3 | 2.5 — 2.9 | 3.8 — 4.3 | 4.6 — 4.9 | 6.0 — 6.2 | 6.4 — 6.7 |
|---|---|---|---|---|---|---|---|---|---|
| Oxidative Functional Group | Phenoxide $+O-\langle\bigcirc\rangle-+$ | Hydroxyl —CH— \| OH  Ether —CH$_2$—O— | Epoxide CH \ O / CH$_2$  Methoxide O ‖ —C—O—$C$ | Diperoxide —C—O—O—C | Carbonyl O ‖ | Ester C=O \| O \| C  Carboxyl C=O \| O \| H | Triether O \| O—C—O | Carbonate O ‖ O—C—O | Ring Structure π–π* |

0 076 562

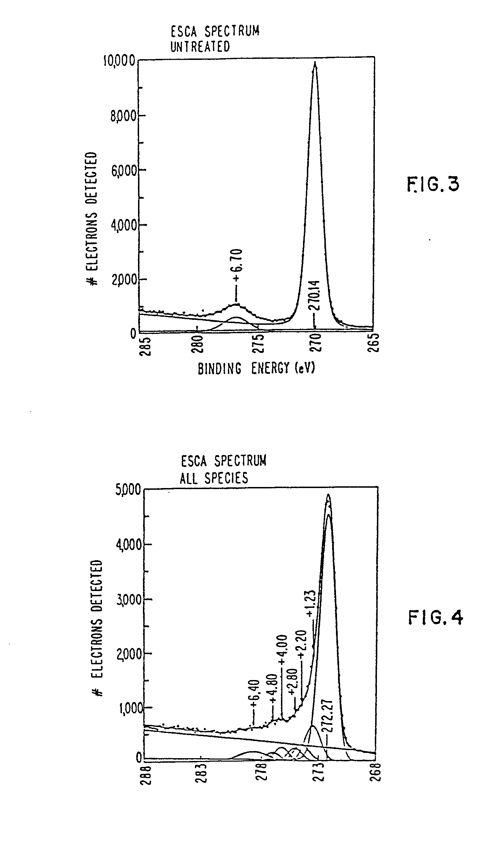

Fig. 3 shows an ESCA scan of an untreated polystyrene substrate. The π–π* peak refers to the ring structure peak. The only other peak is the C—C structure which is the predominant feature of the untreated polystyrene substrate.

Fig. 4 shows the ESCA scan of a polystyrene substrate subjected to exposure to an oxygen plasma containing all of the components of an oxygen plasma. It can be seen that many of the functional groups connected with an oxygen plasma as shown in Table 2 are present in the polystyrene substrate subjected to the full component of the species present in the oxygen plasma.

The following examples illustrate various features of the invention wherein a polystyrene substrate is subjected to a portion of the species of an oxygen plasma.

Example 1 (not in accordance with the present invention)

A sample holder 51 containing a polystyrene sample 47 was located at a distance of 6.35 cm from parallel plate electrodes 35 and 37 in a vacuum chamber 17. The parallel plate electrodes were separated by 21.6 cm. The system was initially pumped to a pressure of 0.4 Pa (3 microns) for 15 minutes. The electrode voltage was maintained at 395 volts RMS at a frequency of 60 Hz during the 3.0 minute treatment with no biased potential applied to the grid assembly or the collector. All grids floated at −2.5v with a collector current of −0.25 µA. Oxygen gas was admitted into the vacuum chamber at a flow rate of 5 cm³/min while maintaining the pressure at 0.8 Pa (6 microns) to establish an oxygen plasma. The resulting surface chemistry from treatment with the full spectrum of active species of the oxygen plasma is shown in Fig. 4. The surface chemistry of an untreated polystyrene specimen as is shown in Fig. 3.

Example 2

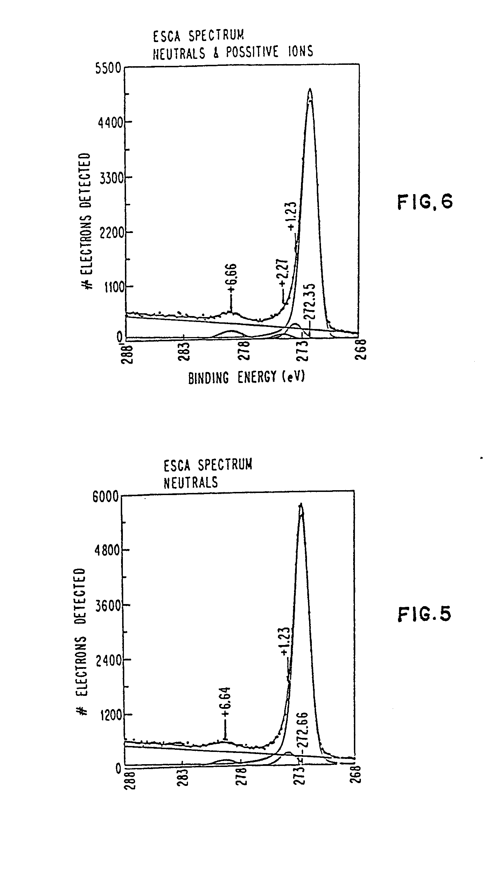

The polystyrene surface was bombarded with only neutral species of the oxygen plasma by biasing grid 3 to +6 v to repel positive ions and by biasing the collector at −6 v to repel negative species. The current to the collector was less than 0.01 µA. The resulting surface chemistry of the sample is illustrated by the ESCA scan set forth in Fig. 5.

Example 3

A polystyrene substrate was then subjected to treatment with neutrals and positive ions from an oxygen plasma by maintaining grid 3 at −9 v and the collector at −60 v. The resulting surface chemistry of the sample is illustrated in the ESCA scan of Fig. 6.

Example 4

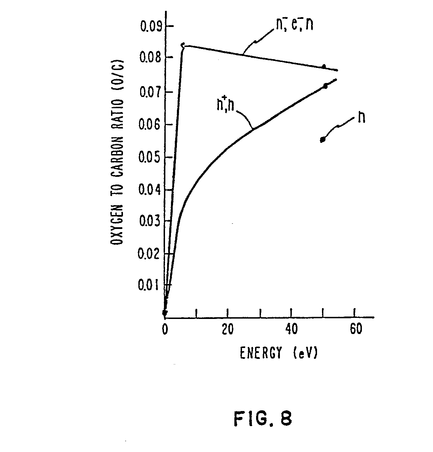

For plasma treatment with negative ions, electrons and neutrals, grid 3 was maintained at a voltage of +1.0 v with a collector voltage of +6 v and collector current of −0.8 µA. The resulting surface chemistry of the sample is illustrated in Fig. 7.

Example 5

The ability to selectively control the extent of oxidation of a surface is demonstrated by varying the energy of the incident ionic species. The following samples were prepared:

| Species | Energy | Grid configuration | Collector current |
|---------|--------|--------------------|-------------------|
| $n^+$, n | $K.E._{ions} < 4ev$ | GRID 3 = −3.0 volts $V_c$ = −6.0 volts | +0.05 µA |
| $n^+$, n | $K.E._{ions} < 10$ ev | GRID 3 = −6.0 volts $V_c$ = −15 volts | +0.22 µA |
| $n^+$, n | $K.E._{ions} < 50$ ev | GRID 3 = −9.0 volts $V_c$ = −60 volts | >+0.30 µA |
| $n^-$, $e^-$, n | $K.E._e - < 8$ ev | GRID 3 = +1.0 volts $V_c$ = +6.0 volts | −0.8 µA |
| n, $e^-$, n | $K.E._e - < 50$ ev | GRID 3 = +8.0 volt $V_c$ = +60.0 volts | <−1.0 µA |

The measured surface oxygen to carbon ratio, O/C, is dependent on both the energy and the ionic species as illustrated in Fig. 8.

The binding energy shifts representative of the various samples of the above examples are set forth in Table 3 hereinbelow.

It is readily apparent from an examination of Table 3 that the present invention can be used to specifically insert various chemical functional groups on substrate surfaces by the process of the invention.

6

TABLE 3
Measured binding energy shifts for selected treatments with oxygen plasma

| Binding energy shift range (eV) | 1.2 — 1.3 | 1.4 — 1.6 | 1.7 — 1.9 | 2.0 — 2.3 | 2.5 — 2.9 | 3.8 — 4.3 | 4.6 — 4.9 | 6.0 — 6.2 | 6.4 — 6.7 |
|---|---|---|---|---|---|---|---|---|---|
| Functional Group | Phenoxide | Hydroxyl Ether | Epoxide Methoxide | Diperoxide | Carbonyl | Ester Carboxyl | Triether | Carbonate | Ring Structure |
| Untreated | | | | | | | | | 6.69 |
| All species | 1.23 | | | 2.20 | 2.80 | 4.0 | 4.80 | | 6.40 |
| Neutrals | 1.23 | | | | | | | | 6.64 |
| Neutrals and Positive ions | 1.23 | | | 2.27 | | | | | 6.66 |
| Neutrals Negative ions and Electrons | 1123 | | | | 2.78 | | | | 6.52 |

0 076 562

# 0 076 562

## Claims

1. A method for providing specific chemical functional groups on the surfaces of organic substrates, the method comprising:

providing an organic substrate (47) within a reaction zone (17);

introducing a vapour material into the reaction zone, the material being suitable for generating a plasma;

subjecting the material to plasma producing conditions to give a plasma which comprises neutral material, positive ions of the material, negative ions of the material, electrons and photons;

contacting the surface of the substrate with components of the plasma; and

forming specific functional groups of the material on the surface of the organic substrate, characterized by the steps of preventing at least one of the components of the plasma from contacting the surface of the organic substrate, and

contacting the surface of the substrate with the remainder of the components of the plasma.

2. A method for providing specific chemical functional groups on the surfaces of inorganic substrates, the method comprising:

providing an inorganic substrate (47) within a reaction zone (17);

introducing a vapour material into the reaction zone, the material being suitable for generating a plasma;

subjecting the material to plasma producing conditions to give a plasma which comprises neutral material, positive ions of the material, negative ions of the material, electrons and photons;

contacting the surface of the substrate with components of the plasma; and

forming specific functional groups of the material on the surface of the inorganic substrate, characterized by the steps of preventing at least one of the components of the plasma from contacting the surface of the organic substrate, and

contacting the surface of the substrate with the remainder of the components of the plasma.

3. A method in accordance with Claim 1 or 2, wherein the plasma is produced under electrical discharge conditions.

4. A method in accordance with Claim 1, 2 or 3, wherein the vapour material is selected from oxygen, nitrogen, halogen, sulphur, compounds thereof and mixtures thereof.

5. A method in accordance with Claim 4, wherein the vapour material is oxygen or a compound thereof.

6. A method in accordance with Claim 4, wherein the vapour material is nitrogen or a compound thereof.

7. A method in accordance with Claim 4, wherein the vapour material is a halogen or a compound thereof.

8. A method in accordance with Claim 4, wherein the vapour material is sulphur or a compound thereof.

## Patentansprüche

1. Verfahren zur Bildung spezifischer chemischer funktioneller Gruppen auf den Oberflächen organischer Substrate, bei dem

—ein organisches Substrat (47) innerhalb einer Reaktionszone (17) bereitgestellt wird;

—ein dampfförmiger Stoff in die Reaktionszone eingeführt wird, wobei der Stoff zur Erzeugung eines Plasmas geeignet ist;

—der Stoff plasmaerzeugenden Bedingungen unter Bildung eines Plasmas unterworfen wird, das neutrales Material, positive Ionen des Stoffs, negative Ionen des Stoffs, Elektronen und Photonen umfaßt;

—die Oberfläche des Substrats mit Komponenten des Plasmas in Berührung gebracht wird; und

—spezifische funktionelle Gruppen aus dem Stoff auf der Oberfläche des organischen Substrats gebildet werden, gekennzeichnet durch die Verfahrensschritte, wonach mindestens eine der Komponenten des Plasmas daran gehindert wird, mit der Oberfläche des organischen Substrats in Kontakt zu kommen, und wonach die Oberfläche des Substrats mit dem Rest der Komponenten des Plasmas in Berührung gebracht wird.

2. Verfahren zur Bildung spezifischer chemischer funktioneller Gruppen auf den Oberflächen anorganischer Substrate, bie dem

—ein anorganisches Substrat (47) innerhalb einer Reaktionszone (17) bereitgestellt wird;

—ein dampfförmiger Stoff in die Reaktionszone eingeführt wird, wobei der Stoff zur Erzeugung eines Plasmas geeignet ist;

—der Stoff plasmaerzeugenden Bedingungen unter Bildung eines Plasmas unterworfen wird, das neutrales Material, positive Ionen des Stoffs, negative Ionen des Stoffs, Elektronen und Photonen umfaßt;

—die Oberfläche des Substrats mit Komponenten des Plasmas in Berührung gebracht wird; und

—spezifische funktionelle Gruppen aus dem Stoff auf der Oberfläche des anorganischen Substrats gebildet werden, gekennzeichnet durch die Verfahrensschritte, wonach mindestens eine der Komponenten des Plasmas daran gehindert wird, mit der Oberfläche des anorganische Substrats in Kontakt zu kommen,

8

**0 076 562**

und wonach die Oberfläche des Substrats mit dem Rest der Komponenten des Plasmas in Kontakt gebracht wird.

3. Verfahren nach Anspruch 1 oder 2, bei dem das Plasma unter den Bedingungen einer elektrischen Entladung erzeugt wird.

4. Verfahren nach Anspruch 1, 2 oder 3, bei dem der dampfförmige Stoff aus Sauerstoff, Stickstoff, Halogen, Schwefel, deren Verbindungen und deren Gemischen ausgewählt wird.

5. Verfahren nach Anspruch 4, bei dem der dampfförmige Stoff Sauerstoff oder eine Verbindung davon ist.

6. Verfahren nach Anspruch 4, bei dem der dampfförmige Stoff Stickstoff oder eine Verbindung davon ist.

7. Verfahren nach Anspruch 4, bei dem der dampfförmige Stoff ein Halogen oder eine Verbindung davon ist.

8. Verfahren nach Anspruch 4, bei dem der dampfförmige Stoff Schwefel oder eine Verbindung davon ist.

**Revendications**

1. Procédé pour disposer des groupes chimiques fonctionnels spécifiques sur les surfaces de substrats organiques, le procédé comportant:

la disposition d'un substrat organique (47) dans une zone de réaction (17),

l'introduction d'une vapeur de matière dans la zone de réaction, la matière convenant pour produire un plasma,

l'exposition de la matière à des conditions de production de plasma pour produire un plasma comportant une matière neutre, des ions positifs de la matière, des ions négatifs de la matière, des électrons et des photons,

la mise en contact de la surface du substrat avec des composants du plasma, et

la formation de groupes fonctionnels spécifiques de la matière sur la surface du substrat organique, caractérisé par les étapes dans lesquelles on empêche qu'au moins l'un des composants du plasma vienne en contact avec la surface du substrat organique, et

on met en contact la surface du substrat avec le reste des composants du plasma.

2. Procédé pour disposer des groupes chimiques fonctionnels spécifiques sur les surfaces de substrats inorganiques, le procédé comportant:

la disposition d'un substrat inorganique (47) dans une zone de réaction (17),

l'introduction d'une vapeur de matière dans la zone de réaction, la matière convenant pour produire un plasma,

l'exposition de la matière à des conditions de production de plasma pour produire un plasma comportant une matière neutre, des ions positifs de la matière, des ions négatifs de la matière, des électrons et des photons,

la mise en contact de la surface du substrat avec des composants du plasma, et

la formation de groupes fonctionnels spécifiques de la matière sur la surface du substrat inorganique, caractérisé par les étapes dans lesquelles on empêche qu'au moins l'un des composants du plasma vienne en contact avec la surface du substrate inorganique, et

on met en contact la surface du substrat avec le reste des composants du plasma.

3. Procédé selon la revendication 1 ou la revendication 2, dans lequel le plasma est produit dans des conditions de décharge électrique.

4. Procédé selon la revendication 1, 2 ou 3, dans lequel la matière de la vapeur est choisie parmi l'oxygène, l'azote, les halogènes, le soufre, leurs composés et leurs mélanges.

5. Procédé selon la revendication 4, dans lequel la matière de la vapeur est l'oxygène ou l'un de ses composés.

6. Procédé selon la revendication 4, dans lequel la matière de la vapeur est l'azote ou l'un de ses composés.

7. Procédé selon la revendication 4, dans lequel la matière de la vapeur est un halogène ou un composé de celui-ci.

8. Procédé selon la revendication 4, dans lequel la matière de la vapeur est le soufre ou l'un de ses composés.

0 076 562

FIG. 1

FIG.7

ESCA SPECTRUM
NEUTRALS, NEG. IONS & ELECTRONS

FIG. 2

1

# 0 076 562

ESCA SPECTRUM
UNTREATED

FIG. 3

ESCA SPECTRUM
ALL SPECIES

FIG. 4

2

**0 076 562**

ESCA SPECTRUM
NEUTRALS & POSSITIVE IONS

FIG. 6

BINDING ENERGY (eV)

ESCA SPECTRUM
NEUTRALS

FIG. 5

3

FIG. 8